(19) Europäisches Patentamt / European Patent Office / Office européen des brevets

(11) **EP 3 988 319 B1**

(12) **EUROPEAN PATENT SPECIFICATION**

(45) Date of publication and mention
of the grant of the patent:
**28.08.2024   Bulletin 2024/35**

(21) Application number: **20826360.8**

(22) Date of filing: **15.06.2020**

(51) International Patent Classification (IPC):
**B41N 3/00** *(2006.01)*      **G03F 7/00** *(2006.01)*
**G03F 7/40** *(2006.01)*      **C09B 67/00** *(2006.01)*
**C09D 11/00** *(2014.01)*      **C09B 67/44** *(2006.01)*
**C09D 11/033** *(2014.01)*      **C09D 11/037** *(2014.01)*
**B41C 1/00** *(2006.01)*      **B41N 3/08** *(2006.01)*
**G03F 7/30** *(2006.01)*      **G03F 7/38** *(2006.01)*

(52) Cooperative Patent Classification (CPC):
**B41N 3/00; C09B 67/0083; C09D 11/033;
C09D 11/037;** B41C 1/00; B41N 3/08; G03F 7/305;
G03F 7/38

(86) International application number:
**PCT/JP2020/023391**

(87) International publication number:
**WO 2020/255918 (24.12.2020 Gazette 2020/52)**

(54) **DYEING METHODS FOR LITHOGRAPHIC PRINTING PLATES**

FÄRBEVERFAHREN FÜR LITHOGRAFISCHE DRUCKPLATTEN

PROCÉDÉS DE TEINTURE POUR PLAQUES D'IMPRESSION LITHOGRAPHIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **20.06.2019   JP 2019114381**

(43) Date of publication of application:
**27.04.2022   Bulletin 2022/17**

(73) Proprietor: **Toray Industries, Inc.
Tokyo 103-8666 (JP)**

(72) Inventors:
• **KUSE Yasunori
  Otsu-shi, Shiga 520-8558 (JP)**
• **INOUE Takejiro
  Otsu-shi, Shiga 520-8558 (JP)**
• **TSUTSUMI Yusuke
  Otsu-shi, Shiga 520-8558 (JP)**

(74) Representative: **Kador & Partner Part mbB
Corneliusstraße 15
80469 München (DE)**

(56) References cited:
EP-A1- 1 234 860        WO-A1-2019/039512
CN-A- 104 893 404       CN-A- 105 440 792
JP-A- 2006 248 049      JP-A- 2010 163 534
JP-A- 2013 203 875      JP-A- 2016 102 270
JP-A- 2018 178 309      JP-A- H0 829 971
JP-A- H06 202 313       JP-A- H1 039 497
JP-A- S63 165 466

**Description**

TECHNICAL FIELD

The present invention relates to a dyeing method for a lithographic printing plate and a method for dyeing an image area formed on a waterless offset lithographic printing plate.

BACKGROUND ART

For a lithographic printing plate, the image area is normally dyed during or after development performed by using an automatic developing machine or the like in order to determine the end point of development for the purpose of improving plate inspection characteristics. In a general method used for such dyeing, only the image area is dyed by spraying a dyeing solution containing a dye or immersing the plate in a dyeing solution.

A normal dyeing solution uses at least one selected from basic dyes, disperse dyes, and acidic dyes dissolved or dispersed in a single-component solvent or a mixed solvent containing one or a plurality selected from water, alcohols, ketones, and ethers. Furthermore, organic acids, inorganic acids, amines, surface active agents, dyeing aids, or the like may be added in order to improve the dyeability.

However, many of such dyeing solutions have the disadvantage that, when used for bulk processing using an automatic developing machine etc., the dyeing density in the image area may deteriorate due to a decrease in dye concentration in the dyeing solution caused by sludge mainly composed of the dye and due to a lowered efficiency in pumping of the dyeing solution caused by foaming in the tank.

To solve this problem, Patent document 1 proposes to dye the image area in a waterless offset lithographic printing plate by using a dyeing solution that contains an anionic surface active agent of a branched structure having 3 to 30 carbon atoms in order to control the generation of sludge and the occurrence of foaming to prevent a decrease in dye concentration (see Patent document 1).

Furthermore, Patent document 2 proposes the inclusion of one or more of dipropylene glycol monoalkyl ethers and tripropylene glycol monoalkyl ethers in addition to the anionic surface active agent of a branched structure having 3 to 30 carbon atoms in an attempt to further improve the foaming prevention effect while suppressing the generation of sludge (see Patent document 2).

Patent documents 3 to 6 disclose dyeing solutions comprising a dye, an anionic surface active agent as represented by formula (1) - as specified herein below - and a solvent selected form ethers and alcohols.

Patent documents 7 and 8 relate to a waterless lithographic printing plates. Patent document 9 relates to a dyeing liquid for waterless photosensitive lithoprinting plates. PRIOR ART DOCUMENTS

PATENT DOCUMENTS

Patent document 1: Japanese Unexamined Patent Publication (Kokai) No. HEI 9-34132
Patent document 2: Japanese Unexamined Patent Publication (Kokai) No. 2004-233610
Patent document 3: CN 105 440 792 A
Patent document 4: CN 104 893 404 A
Patent document 5: JP S63 165466 A
Patent document 6: EP 1234 860 A1
Patent document 7: JP H06 202313 A
Patent document 8: JP H10 39497A
Patent document 9: JP H08 29971

SUMMARY OF INVENTION

PROBLEMS TO BE SOLVED BY THE INVENTION

However, such a dyeing solution containing an anionic surface active agent containing a branched structure having 3 to 30 carbon atoms as described in Patent Document 1 has the disadvantage that, although the lithographic printing plate as a whole does not suffer a significant decrease in dye concentration, imperfect dyeing can occur in some parts of the lithographic printing plate, leading to the problem of so-called "dyeing unevenness", i.e., failure in displaying correct image area ratios in some portions. In addition, sludge composed mainly of the dye may occur if a water-insoluble organic solvent is contained.

Besides, the problem of dyeing unevenness is still likely to occur even when using a dyeing solution containing one or more of dipropylene glycol monoalkyl ethers and tripropylene glycol monoalkyl ethers in addition to an anionic surface active agent of a branched structure having 3 to 30 carbon atoms as described in Patent document 2.

When a waterless offset lithographic printing plate is dyed with a dyeing solution as described in Patent Document 1 or 2, furthermore, there can occur the disadvantage that the dyeing solution does not sufficiently permeate the waterless offset lithographic printing plate, resulting in poor plate inspection characteristics.

Under such circumstances, there is increased demand for a dyeing method for lithographic printing plates, in particular for a method for dyeing an image area formed on a waterless offset lithographic printing plate, that show stable plate inspection characteristics with little decrease in dye concentration and less dyeing unevenness even when used for bulk plate processing.

MEANS OF SOLVING THE PROBLEMS

Thus, a first embodiment of the present invention provides a dyeing method for lithographic printing plates, wherein an image area is dyed using a dyeing solution for lithographic printing plates comprising (a) dye, (b) an anionic surface active agent, and (c) an organic solvent containing at least one selected from ethers and alcohols; during or after the development of a lithographic printing plate precursor and characterized in that the anionic surface active agent (b) is represented by the general formula (1):

$$R^1\text{-}X \qquad (1)$$

wherein $R^1$ represents a linear alkyl group having 3 to 30 carbon atoms or a linear alkenyl group having 3 to 30 carbon atoms, and X represents $SO_3Na$, $SO_3K$, $COONa$, $COONH_4$, or $COOK$.

In addition, a second embodiment of the present invention provides a dyeing method for a waterless offset lithographic printing plate designed to dye an image area formed on the waterless offset lithographic printing plate with a dyeing solution containing an organic solvent, the image area containing a polymer compound and the method being further characterized in that the SP value of the organic solvent, denoted by $\alpha$, and the SP value of the polymer compound, denoted by $\beta$, hold the following relation: $|\beta-\alpha| < 5$, the polymer compound is a phenol resin and/or a melamine resin, the organic solvent is an ether and/or an alcohol, the ether is either dipropylene glycol monoalkyl ether or a tripropylene glycol monoalkyl ether as represented by the general formula (2) given below:

$$R^2\text{-}(OC_3H_6)n\text{-}OH \qquad (2)$$

wherein $R^2$ is $CH_3$, $C_2H_5$, $C_3H_7$, $C_4H_9$, $C_5H_{11}$, or $C_6H_{13}$; n is 2 or 3; and the $(OC_3H_6)$ chains may be independently branched or linear, and the alcohol being either tripropylene glycol or 3-methyl-3-methoxy butanol.

ADVANTAGEOUS EFFECTS OF THE INVENTION

The first embodiment of the present invention involves providing a dyeing solution for lithographic printing plates that shows stable plate inspection characteristics with little decrease in dye concentration and less dyeing unevenness even when used for bulk plate processing. Furthermore, the second embodiment of the present invention can provide a dyeing method for waterless offset lithographic printing plates that shows stable plate inspection characteristics with little decrease in dye concentration and less dyeing unevenness even when used for bulk plate processing.

DESCRIPTION OF PREFERRED EMBODIMENTS

<Dyeing solution for lithographic printing plates used in the method of the first embodiment>

The dyeing solution for lithographic printing plates used in the method of the first embodiment of the present invention is described below.

The dyeing solution for lithographic printing plates used in the method of the first embodiment of the present invention is designed to dye an image area formed on a lithographic printing plate precursor by light exposure and development and it serves to allow the lithographic printing plate to have improved plate inspection characteristics realized by virtue of a difference between the reflection density of the non-image area and the reflection density of the image area (i.e., dye concentration).

The dyeing solution for lithographic printing plates used in the method of the present invention contains (a) a dye. Examples of (a) the dye include basic dyes, acidic dyes, direct dyes, disperse dyes, and reactive dyes, which may be used singly or as a combination of two or more thereof.

Of these examples of (a) the dye, basic dyes are preferred because they can be adsorbed strongly to the image area to achieve a high dye concentration. Examples of the basic dyes include triphenyl methane based basic dyes such as Methyl Violet, Ethyl Violet, Basic Fuchsin, Basic Red 9, Malachite Green Oxalate, Brilliant Green, Victoria Blue B, Crystal Violet, Basic Green 1, Basic Blue 1, Basic Blue 7, and Basic Blue 20; xanthene based basic dyes such as Rhodamine 6G, Rhodamine B, Rhodamine 123, and Rhodamine 19; diphenyl methane based basic dyes such as auramine; azine based basic dyes such as safranine; oxazine based basic dyes such as Basic Blue 3; methine based basic dyes such as Basic Yellow 28, Basic Red 13, and Basic Violet 7; azo based basic dyes such as Basic Orange 2 and Basic Brown 1; and thiazine based basic dyes such as Basic Blue 17, Basic Blue 24, and Methylene Blue. Of these, particularly preferred are triphenyl methane based basic dyes such as Methyl Violet, Ethyl Violet, Basic Fuchsin, Basic Red 9, Victoria Blue B, Crystal Violet, Basic Blue 1, Basic Blue 7, and Basic Blue 20.

In particular, it is preferable for (a) the dye in use to have a maximum absorption wavelength ($\lambda_{max}$) in the wavelength range of 400 to 600 nm. Since many lithographic printing plates have greenish colors, the use of such a dye serves effectively to allow the image area to have a higher dye concentration by virtue of complementary color relations. Thus, this is preferable because it is possible to efficiently increase the dye concentration of the image area and achieve better plate inspection characteristics.

In addition, it is preferable for such (a) a dye to account for 0.05 mass% or more of the dye solution. If the content of the dye is 0.05 mass% or more, it is preferable because it serves to achieve a sufficiently large difference between the reflection density of the non-image area and the reflection density of the image area to ensure improved plate inspection characteristics. It is more preferable for the dye to account for 0.10 mass% or more of the dyeing solution. On the other hand, it is preferable for the dye to account for 5.00 mass% or less of the dyeing solution because it serves for easy control of the generation of sludge and ensures little decrease in dye concentration. It is more preferable for the dye to account for 1.00 mass% or less of the dyeing solution.

The dyeing solution for lithographic printing plates used in the method of the first embodiment of the present invention contains (b) an anionic surface active agent as represented by the general formula (1) given below.

$$R^1\text{-}X \qquad (1)$$

(In the formula, $R^1$ represents a linear alkyl group having 3 to 30 carbon atoms or a linear alkenyl group having 3 to 30 carbon atoms, and X represents $SO_3Na$, $SO_3K$, $COONa$, $COONH_4$, or $COOK$.)

$R^1$ in the general formula (1) is a linear alkyl group having 3 to 30 carbon atoms or a linear alkenyl group having 3 to 30 carbon atoms. It is more preferable for $R^1$ to be a linear alkyl group having 3 to 20 carbon atoms or a linear alkenyl group having 3 to 20 carbon atoms. Being linear, they can serve more effectively in controlling the dyeing unevenness than branched ones. If $R^1$ has 3 or more carbon atoms, it is preferable because it serves to allow the surface active agent to have high cleaning capability and also serves to suppress the generation of sludge to ensure a high dye concentration when used for bulk processing of lithographic printing plates. It preferably has 4 or more, more preferably 6 or more, carbon atoms from the viewpoint of obtaining a dyeing solution that serves to achieve a high dye concentration while ensuring little decrease in dye concentration when used for bulk processing of plates. On the other hand, if $R^1$ has 30 or less carbon atoms, it is preferable because it serves to achieve a moderate hydrophobicity and ensure easy dissolution in the dyeing solution. It preferably has 20 or less, more preferably 12 or less, carbon atoms from the viewpoint of allowing the surface active agent to have high cleaning capability and also serves to suppress dyeing unevenness.

X in the general formula (1) represents a hydrophilic group in the anionic surface active agent and it is at least one selected from the group consisting of $SO_3Na$, $SO_3K$, $COONa$, $COONH_4$, and $COOK$. Selection of an appropriate hydrophilic group serves to efficiently depress dyeing unevenness. In particular, X is preferably SOsNa or COONa, of which SOsNa is more preferable.

Specific examples of (b) the anionic surface active agent represented by the general formula (1) include sodium octadecane sulphonate, sodium hexadecane sulphonate, sodium pentadecane sulfonate, sodium tetradecane sulfonate, sodium dodecane sulfonate, potassium dodecane sulfonate, sodium decane sulfonate, sodium nonane sulfonate, sodium octane sulfonate, sodium heptane sulfonate, sodium hexane sulfonate, sodium pentane sulfonate, sodium behenate, potassium behenate, sodium stearate, ammonium stearate, potassium stearate, sodium oleate, ammonium oleate, potassium oleate, sodium linoleate, ammonium linoleate, potassium linoleate, sodium palmitate, ammonium palmitate, potassium palmitate, sodium myristate, potassium myristate, sodium laurate, ammonium laurate, potassium laurate, sodium decanoate, ammonium decanoate, potassium decanoate, sodium nonanoate, potassium nonanoate, sodium octanoate, potassium octanoate, sodium heptanoate, ammonium heptanoate, potassium heptanoate, sodium hexanoate, ammonium hexanoate, potassium hexanoate, sodium pentanoate, ammonium pentanoate, potassium pentanoate, sodium butyrate, ammonium butyrate, and potassium butyrate. Of these anionic surface active agents, preferable ones include sodium dodecane sulfonate, potassium dodecane sulfonate, sodium decane sulfonate, sodium nonane sulfonate, sodium octane sulfonate, sodium heptane sulfonate, sodium hexane sulfonate, sodium laurate, ammonium laurate, potassium laurate, sodium decanoate, ammonium decanoate, potassium decanoate, sodium nonanoate, potassium nonanoate, sodium octanoate, potassium octanoate, sodium heptanoate, ammonium heptanoate, potassium heptanoate, sodium hexanoate, ammonium hexanoate, and potassium hexanoate. Two or more thereof may be contained together.

It is preferable for these anionic surface active agents to accounts for 0.010 mass% or more in the dyeing solution in order to prevent the generation of sludge in the dyeing solution and ensure little decrease in dye concentration and smaller dyeing unevenness. It is more preferable for the anionic surface active agents to account for 0.020 mass% or more in the dyeing solution. On the other hand, their contents in the dyeing solution are preferably 2.0 mass% or less, more preferably 1.0 mass% or less, in the dyeing solution in order to suppress foaming in the dyeing solution and prevent a decrease in dye concentration.

The dyeing solution for lithographic printing plates used in the method of the first embodiment of the present invention contains (c) an organic solvent containing at least one selected from ethers and alcohols. Examples of (c) the ethers and alcohols include ethers such as cyclic ethers, monoethers, and polyethers, and alcohols such as monovalent alcohols, divalent alcohols, and trivalent alcohols, which may be used singly or as a combination of two or more thereof.

From the viewpoint of ensuring little decrease in dye concentration and suppressed dyeing unevenness, preferred ethers for use in a dyeing solution for the lithographic printing plates used in the method of the first embodiment of the present invention include alkylene glycol alkyl ethers such as ethylene glycol monoethyl ether, ethylene glycol monopropyl ether, ethylene glycol monobutyl ether, ethylene glycol monohexyl ether, ethylene glycol monoheptyl ether, ethylene glycol monooctyl ether, ethylene glycol dibutyl ether, diethylene glycol monomethyl ether, diethylene glycol dimethyl ether, diethylene glycol monoethyl ether, diethylene glycol monobutyl ether, diethylene glycol dibutyl ether, diethylene glycol monohexyl ether, diethylene glycol monoheptyl ether, diethylene glycol monooctyl ether, triethylene glycol monomethyl ether, triethylene glycol dimethyl ether, triethylene glycol monobutyl ether, triethylene glycol monopentyl ether, triethylene glycol monohexyl ether, tetraethylene glycol dimethyl ether, propylene glycol monomethyl ether, propylene glycol monopropyl ether, propylene glycol monobutyl ether, propylene glycol monopentyl ether, propylene glycol monohexyl ether, propylene glycol monoheptyl ether, propylene glycol monooctyl ether, dipropylene glycol monomethyl ether, dipropylene glycol monobutyl ether, dipropylene glycol monopentyl ether, dipropylene glycol monohexyl ether, dipropylene glycol monooctyl ether, and tripropylene glycol dimethyl ether.

Of these, dipropylene glycol monoalkyl ethers and tripropylene glycol monoalkyl ethers as represented by the general formula (2) are preferred from the viewpoint of being more effective in suppressing dyeing unevenness.

$$R^2\text{-}(OC_3H_6)n\text{-}OH \qquad (2)$$

(In the general formula (2), $R^2$ is any of $CH_3$, $C_2H_5$, $C_3H_7$, $C_4H_9$, $C_5H_{11}$, and $C_6H_{13}$; n is 2 or 3; and the $(OC_3H_6)$ chains may be independently branched or linear.)

Specific examples of such dipropylene glycol monoalkyl ethers and tripropylene glycol monoalkyl ethers include dipropylene glycol monomethyl ether, dipropylene glycol monoethyl ether, dipropylene glycol monopropyl ether, dipropylene glycol monobutyl ether, dipropylene glycol monohexyl ether, tripropylene glycol monomethyl ether, tripropylene glycol monoethyl ether, tripropylene glycol monopropyl ether, and tripropylene glycol monobutyl ether, of which tripropylene glycol monoalkyl ethers having an n of 3 in the general formula (2) such as tripropylene glycol monomethyl ether, tripropylene glycol monoethyl ether, tripropylene glycol monopropyl ether, and tripropylene glycol monobutyl ether are preferred.

Alcohols and ethers to be used as the (c) organic solvent in the dyeing solution for lithographic printing plates according to the first embodiment of the present invention preferably has a solubility parameter (SP value) of 9.0 to 13.0 $(cal/cm^3)^{1/2}$ (18.45 to 26.65 $(MPa)^{1/2}$) to allow easy penetration of the dyeing solution into the image area in the lithographic printing plate and achieve a higher dye concentration to ensure better plate inspection characteristics. The SP value can be calculated by the Fedors estimation method. Specific examples of such an alcohol include ethanol, n-propanol, isopropanol, n-butanol, 2-butanol, tert-butanol, n-hexanol, 3-methoxy butanol, 3-methyl-3-methoxy butanol, tetraethylene glycol, and tripropylene glycol. Specific examples of such an ether include ethylene glycol monoethyl ether, ethylene glycol monopropyl ether, ethylene glycol monobutyl ether, ethylene glycol monohexyl ether, ethylene glycol monoheptyl ether, ethylene glycol monooctyl ether, diethylene glycol monomethyl ether, diethylene glycol monoethyl ether, diethylene glycol monobutyl ether, diethylene glycol monohexyl ether, diethylene glycol monoheptyl ether, diethylene glycol monooctyl ether, triethylene glycol monomethyl ether, triethylene glycol monobutyl ether, triethylene glycol monopentyl ether, triethylene glycol monohexyl ether, propylene glycol monomethyl ether, propylene glycol monopropyl ether, propylene glycol monobutyl ether, propylene glycol monopentyl ether, propylene glycol monohexyl ether, propylene glycol monoheptyl ether, propylene glycol monooctyl ether, dipropylene glycol monomethyl ether, dipropylene glycol monoethyl ether, dipropylene glycol monopropyl ether, dipropylene glycol monobutyl ether, dipropylene glycol monopentyl ether, dipropylene glycol monohexyl ether, dipropylene glycol monooctyl ether, tripropylene glycol monomethyl ether, tripropylene glycol monoethyl ether, tripropylene glycol monopropyl ether, and tripropylene glycol monobutyl ether. In particular, tripropylene glycol and 3-methyl-3-methoxy butanol are preferred in terms of dyeability, safety, and cost. For alcohols and ethers, the SP value is more preferably 9.5 to 12.5 $(cal/cm^3)^{1/2}$ (19.48 to 25.63 $(MPa)^{1/2}$).

Furthermore, alcohols and ethers to be used as (c) the organic solvent in the dyeing solution for lithographic printing plates used in the method of the first embodiment of the present invention preferably has a vapor pressure of 2,000 Pa or less at 20°C under 1 atm. This is because when an alcohol or an ether is combined with water to provide a mixed solvent to be used as solvent for a dyeing solution, the generation of sludge can be controlled and the decrease in dye concentration can be further suppressed if the alcohol or ether has a vapor pressure of 2,000 Pa or less at 20°C. This is thought to be because when water, which has a vapor pressure of 2,330 Pa at 20°C, is combined with an alcohol or ether having a vapor pressure of 2,000 Pa or less at 20°C, the amount of the alcohol or ether evaporated from the dyeing solution during bulk processing is smaller than that of water, which allows the dye to have higher dissolution stability in the dyeing solution to suppress the generation of sludge. Examples of such an alcohol include n-propanol, n-butanol, 2-butanol, tert-butanol, n-hexanol, 3-methyl-3-methoxy butanol, tetraethylene glycol, and tripropylene glycol, of which 3-methyl-3-methoxy butanol is preferred. Furthermore, specific examples of such an ether include ethylene glycol monoethyl ether, ethylene glycol monopropyl ether, ethylene glycol monobutyl ether, ethylene glycol monohexyl ether, ethylene glycol monoheptyl ether, ethylene glycol monooctyl ether, diethylene glycol monomethyl ether, diethylene glycol monoethyl ether, diethylene glycol monobutyl ether, diethylene glycol monohexyl ether, diethylene glycol monoheptyl ether, diethylene glycol monooctyl ether, triethylene glycol monomethyl ether, triethylene glycol monobutyl ether, triethylene glycol monopentyl ether, triethylene glycol monohexyl ether, propylene glycol monomethyl ether, propylene glycol monopropyl ether, propylene glycol monobutyl ether, propylene glycol monopentyl ether, propylene glycol monohexyl ether, propylene glycol monoheptyl ether, propylene glycol monooctyl ether, dipropylene glycol monomethyl ether, dipropylene glycol monoethyl ether, dipropylene glycol monopropyl ether, dipropylene glycol monobutyl ether, dipropylene glycol monopentyl ether, dipropylene glycol monohexyl ether, dipropylene glycol monooctyl ether, tripropylene glycol monomethyl ether, tripropylene glycol monoethyl ether, tripropylene glycol monopropyl ether, and tripropylene glycol monobutyl ether.

In the dyeing solution for lithographic printing plates used in the method of the first embodiment of the present invention, the organic solvent containing at least one of (c) the ethers and alcohols preferably accounts for 3.0 mass% to 30.0 mass%, more preferably 5.0 mass% to 25.0 mass%, and still more preferably 7.5 mass% to 20.0 mass%, of the dyeing solution. If (c) the ethers and alcohols account for 3.0 mass% or more, it ensures easy penetration of the dyeing solution into the image area in the lithographic printing plate and serves to maintain a high dye concentration state. On the other hand, if their content is 30.0 mass% or less, it is not disadvantageous from an economic point of view, but serves to prevent the removal of the non-image area from the lithographic printing plate.

<Dyeing method for lithographic printing plates containing the dyeing solution for lithographic printing plates according to the first embodiment>

The dyeing method for lithographic printing plates containing the dyeing solution for lithographic printing plates according to the first embodiment includes a step for dyeing the image area with the dyeing solution for lithographic printing plates according to the first embodiment of the present invention during or after development of a lithographic printing plate precursor. The lithographic printing plate precursor, the production method for lithographic printing plates, and the dyeing method are identical to the <lithographic printing plate precursor used for the second embodiment>, the <production method for the lithographic printing plates used for the second embodiment>, and the <dyeing method for lithographic printing plates according to the second embodiment> described later.

<Dyeing solution used for the second embodiment>

The dyeing solution used for the second embodiment of the present invention contains an organic solvent and, in order to dye the image area formed on the lithographic printing plate, it holds the relation $|\beta-\alpha| < 5$ $(cal/cm^3)^{1/2}$ ($|\beta-\alpha| < 10.25$ $(MPa)^{1/2}$) wherein $\beta$ is the solubility parameter (SP value) of the polymer compound contained in the image area while $\alpha$ is the SP value of the organic solvent.

The organic solvent contained in the dyeing solution used for the second embodiment of the present invention serves to slightly dissolve the image area formed on the lithographic printing plate and allows the dye to penetrate into the image area, thereby improving the dyeability. Therefore, the SP value $\beta$ of the polymer compound contained in the image area and the SP value $\alpha$ of the organic solvent are preferably close to each other and hold the relation $|\beta-\alpha| < 5$ $(cal/cm^3)^{1/2}$ ($|\beta-\alpha| < 10.25$ $(MPa)^{1/2}$). The SP value can be calculated by the Fedors estimation method.

Here, in the case where the image area contains a plurality of polymer compounds or where the dyeing solution used for the second embodiment according to the present invention contains a plurality of organic solvents, the SP value of each component is multiplied by its content ratio and summed up to provide the SP value to be used above. For example, in the case where the dyeing solution used for the second embodiment according to the present invention contains an organic solvent 1 (having a SP value of $\alpha_1$) and an organic solvent 2 (having a SP value of $\alpha_2$) in the ratio

of 6:4 by mass, the SP value $\alpha$ of the organic solvent is calculated as $\alpha_1 \times 0.6 + \alpha_2 \times 0.4$.

Furthermore, in order to achieve an increased dye concentration while preventing the fixation of the dye due to excessive dissolution of the image area, it is preferable that the relation $1 < \beta - \alpha < 5$ $(cal/cm^3)^{1/2}$ ($2.05 < \beta - \alpha < 10.25$ $(MPa)^{1/2}$) be held.

It is more preferable for any polymer compound contained in the image area to have a SP value of 10 to 17 $(cal/cm^3)^{1/2}$ (20.5 to 34.85 $(MPa)^{1/2}$), more preferably 12 to 17 $(cal/cm^3)^{1/2}$ (24.6 to 34.85 $(MPa)^{1/2}$). Examples of such polymer compounds include phenol resins such as phenol novolac resin (SP value: 16.4 $(cal/cm^3)^{1/2}$ (33.62 $(MPa)^{1/2}$)) and cresol novolac resin (SP value: 15.2 $(cal/cm^3)^{1/2}$ (31.16 $(MPa)^{1/2}$)); melamine resins such as imino type methylated melamine resin (SP value: 13.8 $(cal/cm^3)^{1/2}$ (28.29 $(MPa)^{1/2}$)), methylol type methylated melamine resin (SP value: 11.5 $(cal/cm^3)^{1/2}$ (23.58 $(MPa)^{1/2}$)), and alkyl type methylated melamine resin (SP value: 10.5 $(cal/cm^3)^{1/2}$ (21.53 $(MPa)^{1/2}$)). In particular, the use of a phenol resin and/or a melamine resin has the benefit of not being dissolved excessively in the organic solvent and not causing significant dyeing unevenness.

For the combination of an organic solvent (SP value $\alpha$) and a polymer compound (SP value $\beta$), any organic solvent and polymer compound cited herein can be used and, for example, a combination of an alcohol and a novolac resin or a combination of an alcohol and a melamine resin may be adopted. In particular, it is preferable to use a combination of a tripropylene glycol and a phenol novolac resin, a combination of a tripropylene glycol and an imino type methylated melamine resin, a combination of a dipropylene glycol monobutyl ether and an imino type methylated melamine resin, or a combination of a 3-methyl-3-methoxy butanol and an imino type methylated melamine resin.

It is preferable for the organic solvent contained in the dyeing solution used for the second embodiment according to the present invention to have a SP value of 9.0 to 13.0 $(cal/cm^3)^{1/2}$ (18.45 to 26.65 $(MPa)^{1/2}$) because it serves to realize easy penetration of the dyeing solution into the image area in the lithographic printing plate to ensure a higher dye concentration, thereby leading to better plate inspection characteristics. Furthermore, the organic solvent is an ether and/or an alcohol, and the ether is either dipropylene glycol monoalkyl ether or a tripropylene glycol monoalkyl ether as represented by the general formula (2) given below:

$$R^2\text{-}(OC_3H_6)n\text{-}OH \qquad (2)$$

wherein $R^2$ is $CH_3$, $C_2H_5$, $C_3H_7$, $C_4H_9$, $C_5H_{11}$, or $C_6H_{13}$; n is 2 or 3; and the $(OC_3H_6)$ chains may be independently branched or linear, and the alcohol being either tripropylene glycol or 3-methyl-3-methoxy butanol.

The dyeing solution used for the second embodiment according to the present invention may contain (a) a dye as defined for the first embodiment.

The dyeing solution used for the second embodiment according to the present invention may contain an anionic surface active agent as defined for the first embodiment. More preferably, it contains an anionic surface active agent as represented by the general formula (3) given below.

$$R^1\text{-}X \qquad (3)$$

(In the formula, $R^1$ represents a linear alkyl group having 6 to 10 carbon atoms, and X represents $SO_3Na$, $SO_3K$, $COONa$, $COONH_4$, or $COOK$.)

Specific examples of such an anionic surface active agent include those anionic surface active agents as represented by the general formula (1) given above.

<Lithographic printing plate precursor used for the second embodiment>

Next, the lithographic printing plate precursor used for the second embodiment of the present invention is described below. The lithographic printing plate precursor used for the second embodiment of the present invention can be applied to waterless offset printing plates. In particular, from the viewpoint of dyeability, it is applied to waterless offset printing plates. A waterless offset printing plate used for the second embodiment of the present invention has a substrate. In addition, it also has at least a heat-sensitive layer and an ink repellent layer on or above the substrate. Either of the heat-sensitive layer and ink repellent layer may be located nearer to the substrate, but it is preferable for the substrate, the heat-sensitive layer, and the ink repellent layer to be disposed in this order.

The heat-sensitive layer of a waterless offset printing plate contains a polymer compound. The polymer compound is identical to the polymer compound contained in the image area described in the above section <Dyeing solution used for the second embodiments The polymer compound preferably accounts for 50 mass% or more, more preferably 70 mass% or more, in the heat-sensitive layer of a waterless offset lithographic printing plate. If the polymer compound accounts for 50 mass% or more, it is preferable because it ensures a small dyeing unevenness and stable plate inspection characteristics. Furthermore, the polymer compound preferably accounts for 95 mass% or less, more preferably 90 mass% or less, in the heat-sensitive layer of a waterless offset lithographic printing plate. If the polymer compound accounts for 95 mass% or less, it is preferable because it serves to suppress excessive dissolution of the image area by the dyeing solution and prevent a decrease in dye concentration.

<Production method for lithographic printing plate used for the second embodiment>

To produce a lithographic printing plate used for the second embodiment, the lithographic printing plate precursor described above is processed by a method including whether the step (a) or the step (2) described below:

   step (1) including a step (A) for performing light exposure according to an image (light exposure step), and
   step (2) performed after the step (A) for performing light exposure and including a step (B) for applying physical friction to the light-exposed lithographic printing plate precursor to remove the ink repellent layer in the light-exposed region (development step).

The resulting lithographic printing plate is the remainder of the lithographic printing plate precursor left after removing a part of the ink repellent layer that corresponds to the light-exposed region of the surface.

First, the light exposure step (A) is described below. In the light exposure step (A), the lithographic printing plate precursor is exposed to light according to an image. In the case of a lithographic printing plate precursor having a protective film, light may be applied through the protective film or after removing the protective film. For the light exposure step (A), it is preferable to use a light source in the emission wavelength range of 300 nm to 1,500 nm. In particular, the use of a semiconductor laser or a YAG laser having an emission wavelength range near the near infrared region is preferred because wavelengths in this range are widely adopted as absorption wavelengths of heat-sensitive layers. Specifically, laser beams having wavelengths of 780 nm, 808 nm, 830 nm, or 1,064 nm are used suitably for light exposure from the viewpoint of the efficiency of conversion into heat. The light exposure is preferably 150 mJ/cm$^2$ or more in order to cause heat decompose of the image area to ensure easy penetration of the dyeing solution and an increase in dye concentration.

Next, the development step (B) is described below. In the development step (B), physical friction is applied to the light-exposed lithographic printing plate precursor to remove the ink repellent layer in the light-exposed region. Useful methods for applying physical friction include (i) a method of wiping the plate surface with nonwoven fabric, absorbent cotton, cloth, sponge, or the like, containing a developer, (ii) a method of pre-treating the plate surface with a developer and subsequently rubbing it with a rotating brush in a shower of tap water or the like, and (iii) a method of applying a jet of high pressure water, warm water, or water vapor onto the plate surface.

Prior to development, the lithographic printing plate precursor may be pre-treated by immersing it in a pre-treatment liquid for a certain period of time. Examples of the pre-treatment liquid include water, water containing a polar solvent such as alcohol, ketone, ester, or carboxylic acid, a solution prepared by adding a polar solvent to a solvent containing at least one of aliphatic hydrocarbons, aromatic hydrocarbons, and the like, and polar solvents. Another example of the pre-treatment liquid is one that contains a polyethylene ether diol and a diamine compound having two or more primary amino groups as described in Japanese Patent No. 4839987. More specific examples of the pre-treatment liquid include PP-1, PP-3, PP-F, PP-FII, PTS-1, CP-1, CP-Y, NP-1, and DP-1 (all manufactured by Toray Industries, Inc.).

Useful developers include, for example, water, an aqueous solution in which water accounts for 50 mass% or more of the entire solution, alcohol, and paraffin based hydrocarbon. Other examples include mixtures of water and propylene glycol derivatives such as propylene glycol, dipropylene glycol, triethylene glycol, polypropylene glycol, and alkylene oxide adducts to polypropylene glycol. More specific examples of the developer include HP-N and WH-3 (both manufactured by Toray Industries, Inc.). A conventional surface active agent may also be added as a component of the developer. From the viewpoint of safety, disposal cost, and the like, it is preferable to use a surface active agent that forms an aqueous solution having a pH of 5 to 8. The surface active agent preferably accounts for 10 mass% or less of the developer. Such a developer is very safe and also preferred in terms of economical features such as disposal cost. On the other hand, the developer in use is preferably free of organic solvents in order to prevent dyeing unevenness from being caused by excessive dissolution of the light-exposed region (image area).

<Dyeing method for lithographic printing plates according to the second embodiment>

Then, the exposed region (image area) deprived of the ink repellent layer is dyed with the dyeing solution used for the second embodiment according to the present invention. Here, dyeing of the image area with a dyeing solution may be performed simultaneously with development or dyeing may be performed after development. In the dyeing step, furthermore, rubbing with a brush etc. may be performed while dyeing in order to enhance the degree of level dyeing and achieve supplementary development of portions left incompletely light-exposed in the development step. A step for drying the dyeing solution on the image area may be included in order to increase the dye concentration by fixing the dye after the contact of the dyeing solution with the image area. Useful drying methods include heating and airblowing, although there are no specific limitations thereon.

A part or the entirety of the above development step can be automated using an automatic developing machine. Useful automatic developing machines include the following: an apparatus containing only a developing unit, an apparatus containing a pre-treatment unit and a developing unit in this order, an apparatus containing a pre-treatment unit, a developing unit, and a post-treatment unit in this order, and an apparatus containing a pre-treatment unit, a developing unit, a post-treatment unit, and a rinsing unit in this order. Specific examples of such automatic developing machines include the TWL-650 series, TWL-860 series, and TWL-1160 series (all manufactured by Toray Industries, Inc.), and an automatic developing machine equipped with a bearer having a curved dent to reduce scratches on the back of the plate as described in Japanese Unexamined Patent Publication (Kokai) No. HEI 5-6000. These may be used in combination. When using such an automatic development machine, the dyeing solution according to the present invention is preferably introduced into the post-treatment unit.

In preparation for storing the developed lithographic printing plates stacked in a pile, it is preferable to provide interleaving paper sheets between the plates in order to protect the plate surfaces.

The present invention will now be illustrated with reference to Examples, but the present invention should not be construed as being limited thereto.

EXAMPLES

(1) Evaluation of dye concentration

(1) Plate preparation in Examples 1 to 10 and Comparative examples 1 to 5

Toray waterless offset lithographic printing plate IMPRIMA™ MC (manufactured by Toray Industries, Inc., image area containing a polymer compound consisting of phenol novolac resin and polyurethane at 70.6:29.4, the polymer compound having a SP value $\beta$ of 14.5 $(cal/cm^3)^{1/2}$) was exposed to light using a light exposure machine for CTP (PlateRite HD 8900N-E, manufactured by Dainippon Screen Mfg. Co., Ltd.) under the condition of an exposure energy of 180 $mJ/cm^2$ (drum rotating speed: 140 rpm). Then, a solid image and 50% halftone dot image were formed at 2,400 dpi and 175 lpi on a lithographic printing plate precursor having a size of 560 mm in length and 330 mm in width. After feeding tap water to the pre-treatment tank and development tank, feeding a dyeing solution prepared in each Example or Comparative example (dyeing solution 1 for lithographic printing plates to dyeing solution 15 for lithographic printing plates) to the post-treatment tank, and feeing tap water to the rinsing tank in an automatic development machine (TWL-1160F, manufactured by Toray Industries, Inc.), light-exposed precursors were passed through at a speed of 40 cm/min, thereby preparing a total of 1,000 lithographic printing plates.

(1-2) Plate preparation in Examples 11 to 20 and Comparative example 6

Any of waterless offset lithographic printing plate precursor 1 to waterless offset lithographic printing plate precursor 4, which had an image layer containing a specified polymer compound as described in each Example or Comparative example, was exposed to light using a light exposure machine for CTP (PlateRite HD 8900N-E, manufactured by Dainippon Screen Mfg. Co., Ltd.) under the conditions of an exposure energy of 125 $mJ/cm^2$ (Examples 11 to 17 and Comparative example 6) or 150 $mJ/cm^2$ (Examples 18 to 20). Then, a solid image and 50% halftone dot image were formed at 2,400 dpi and 175 lpi on a lithographic printing plate precursor having a size of 560 mm in length and 330 mm in width. After feeding tap water to the pre-treatment tank, feeding a 10% aqueous triethylene glycol solution (Examples 11 to 18 and Comparative example 6) or tap water (Examples 19 and 20) to the development tank, feeding a dyeing solution as described in each Example or Comparative example (dyeing solution 16 for lithographic printing plates to dyeing solution 21 for lithographic printing plates) to the post-treatment tank, and feeding tap water to the rinsing tank in an automatic development machine (TWL-1160F, manufactured by Toray Industries, Inc.), light-exposed precursors were passed through at a speed of 40 cm/min, thereby preparing a total of 1,000 lithographic printing plates. In Example 20, furthermore, the light-exposed precursor, after passing though the post-treatment tank, was dried in hot air to remove the post-treatment solution from the image area using a hot air generator (HAP3051, manufactured by Hakko Electric Co., Ltd.) under the conditions of an air supply rate of 2 $m^3/min$, outlet air temperature of 100°C, and outlet-to-image area distance of 10 cm.

From among the lithographic printing plates prepared in (1-1) and (1-2), the first lithographic printing plate was taken and its solid image was examined using a reflection density measuring instrument (Spectro Eye, manufactured by X-rite). Then the resulting reflection density measurement was adopted to represent the reflection density of the image area. Subsequently, the non-image area was examined using a reflection density measuring instrument (Spectro Eye, manufactured by X-rite), and the resulting measurement was adopted to represent the reflection density of the non-image area. Reflection density measurements were taken using a cyan, yellow, or magenta filter to determine the difference between the reflection density of the non-image area and that of the image area with each filter installed. Among the absolute values of the differences, which are denoted by $\Delta D_C$, $\Delta D_Y$, and $\Delta D_M$, the largest one was adopted to represent the dye concentration. Then, the 1,000th lithographic printing plate was examined to determine its dye concentration by the same procedure. A plate is is judged to be practically acceptable if it has a dye concentration of 0.25 or more, preferably 0.40 or more, more preferably 0.50 or more, still more preferably 0.60 or more, and still more preferably 0.70 or more.

The reflection density measurement instrument (Spectro Eye, manufactured by X-rite) was set up as follows: built-in filter "No", white base "Auto", light source "D50", observation field of view "2°" and concentration standard "ISO T". Then, after selecting the "cyan filter" in the concentration measurement mode setting, the reflection density of the light-exposed portion and that of the non-exposed portion were measured. Subsequently, the same measurement procedure was carried out after replacing the filter with the yellow one and with the magenta one.

(2) Evaluation of dye concentration retention rate

The dye concentration retention rate was calculated by the equation (I) given below where (A) is the dye concentration of the first lithographic printing plate and (B) is the dye concentration of the 1,000th lithographic printing plate. A plate is judged to be practically acceptable if it has a dye concentration retention rate of 75.0% or more, preferably 80.0% or more, more preferably 90.0% or more, still more preferably 95.0% or more, and still more preferably 98.0% or more.

$$\text{Dye concentration retention rate (\%)} = (B)/(A) \times 100 \qquad (I)$$

(3) Evaluation of dyeing unevenness

For the 1,000 lithographic printing plates prepared in the section "(1) Evaluation of dye concentration", 50% halftone areas were examined using Spectro Eye (manufactured by X-rite) to measure the image area rate, followed by counting the number of plates that suffered dyeing unevenness, that is, those containing regions in which the image area rate was 40% or less. A group of plates is judged to be practically acceptable if the number of plates suffering dyeing unevenness is 20 or less, preferably 15 or less, more preferably 12 or less, still more preferably 8 or less, and still more preferably 4 or less.

[Example 1]

The dyeing solution 1 for lithographic printing plates was prepared by stirring and mixing the following components at room temperature.

<Dyeing solution 1 for lithographic printing plates>

(a) Dye: Rhodamine 6G (xanthene based basic dye) (manufactured by Tokyo Chemical Industry Co., Ltd.): 0.250 parts by mass
(b) Anionic surface active agent: sodium behenate (represented by the general formula (1) where $R^1$ is a linear alkyl group having 21 carbon atoms and X is COONa): 0.025 parts by mass
(c) Organic solvent: methanol (alcohol having a SP value $\alpha$ of 13.8 $(cal/cm^3)^{1/2}$ and a vapor pressure of 12,300 Pa (20°C)) (manufactured by Wako Pure Chemical Corporation): 9.0 parts by mass
(d) Water: 90.7 parts by mass

Here, the total quantity of the above components (a) to (d) of the dyeing solution for lithographic printing plates accounts for 100 parts by mass.
The dyeing solution 1 for lithographic printing plates was evaluated by the methods described above and good results were obtained as follows: the first plate had a dye concentration of 0.45; the 1,000th plate had a dye concentration of 0.35; the dye concentration retention rate was 77.8%; and 18 plates suffered dyeing unevenness.

[Example 2]

The dyeing solution 2 for lithographic printing plates, instead of the dyeing solution 1 for lithographic printing plates, was evaluated by the same methods as used for Example 1.

<Dyeing solution 2 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium behenate (represented by the general formula (1) where $R^1$ is a linear alkyl group having 21 carbon atoms and X is COONa): 0.025 parts by mass
(c) Organic solvent: methanol (alcohol having a SP value $\alpha$ of 13.8 $(cal/cm^3)^{1/2}$ and a vapor pressure of 12,300 Pa (20°C)) (manufactured by Wako Pure Chemical Corporation): 9.0 parts by mass
(d) Water: 90.7 parts by mass

Here, the total quantity of the above components (a) to (d) of the dyeing solution for lithographic printing plates accounts for 100 parts by mass.

The dyeing solution 2 for lithographic printing plates was evaluated by the methods described above and good results were obtained as follows: the first plate had a dye concentration of 0.61; the 1,000th plate had a dye concentration of 0.47; the dye concentration retention rate was 77.0%; and 18 plates suffered dyeing unevenness.

[Example 3]

The dyeing solution 3 for lithographic printing plates, instead of the dyeing solution 1 for lithographic printing plates, was evaluated by the same methods as used for Example 1.

<Dyeing solution 3 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium stearate (represented by the general formula (1) where $R^1$ is a linear alkyl group having 17 carbon atoms and X is COONa) (manufactured by Showa Chemical Industry Co., Ltd.): 0.025 parts by mass
(c) Organic solvent: methanol (alcohol having a SP value $\alpha$ of 13.8 $(cal/cm^3)^{1/2}$ and a vapor pressure of 12,300 Pa (20°C)) (manufactured by Wako Pure Chemical Corporation): 9.0 parts by mass
(d) Water: 90.7 parts by mass

Here, the total quantity of the above components (a) to (d) of the dyeing solution for lithographic printing plates accounts for 100 parts by mass.

The dyeing solution 3 for lithographic printing plates was evaluated by the methods described above and good results were obtained as follows: the first plate had a dye concentration of 0.55; the 1,000th plate had a dye concentration of 0.42; the dye concentration retention rate was 76.4%; and 14 plates suffered dyeing unevenness.

[Example 4]

The dyeing solution 4 for lithographic printing plates, instead of the dyeing solution 1 for lithographic printing plates, was evaluated by the same methods as used for Example 1.

<Dyeing solution 4 for lithographic printing plates>

(a) Dye: Ethyl Violet (triphenyl methane based basic dye) (manufactured by Tokyo Chemical Industry Co., Ltd.): 0.250 parts by mass

(b) Anionic surface active agent: sodium octane sulfonate (represented by the general formula (1) where $R^1$ is a linear alkyl group having 8 carbon atoms and X is $SO_3Na$) (manufactured by Tokyo Chemical Industry Co., Ltd.): 0.025 parts by mass

(c) Organic solvent: methanol (alcohol having a SP value $\alpha$ of 13.8 $(cal/cm^3)^{1/2}$ and a vapor pressure of 12,300 Pa (20°C)) (manufactured by Wako Pure Chemical Corporation): 9.0 parts by mass

(d) Water: 90.7 parts by mass

Here, the total quantity of the above components (a) to (d) of the dyeing solution for lithographic printing plates accounts for 100 parts by mass.

The dyeing solution 4 for lithographic printing plates was evaluated by the methods described above and good results were obtained as follows: the first plate had a dye concentration of 0.52; the 1,000th plate had a dye concentration of 0.40; the dye concentration retention rate was 76.9%; and 10 plates suffered dyeing unevenness.

[Example 5]

The dyeing solution 5 for lithographic printing plates, instead of the dyeing solution 1 for lithographic printing plates, was evaluated by the same methods as used for Example 1.

<Dyeing solution 5 for lithographic printing plates>

(a) Dye: Ethyl Violet (triphenyl methane based basic dye) (manufactured by Tokyo Chemical Industry Co., Ltd.): 0.250 parts by mass

(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.025 parts by mass

(c) Organic solvent: methanol (alcohol having a SP value $\alpha$ of 13.8 $(cal/cm^3)^{1/2}$ and a vapor pressure of 12,300 Pa (20°C)) (manufactured by Wako Pure Chemical Corporation): 9.0 parts by mass

(d) Water: 90.7 parts by mass

Here, the total quantity of the above components (a) to (d) of the dyeing solution for lithographic printing plates accounts for 100 parts by mass.

The dyeing solution 5 for lithographic printing plates was evaluated by the methods described above and good results were obtained as follows: the first plate had a dye concentration of 0.52; the 1,000th plate had a dye concentration of 0.40; the dye concentration retention rate was 76.9%; and 10 plates suffered dyeing unevenness.

[Example 6]

The dyeing solution 6 for lithographic printing plates, instead of the dyeing solution 1 for lithographic printing plates, was evaluated by the same methods as used for Example 1.

<Dyeing solution 6 for lithographic printing plates>

(a) Dye: Ethyl Violet (triphenyl methane based basic dye) (manufactured by Tokyo Chemical Industry Co., Ltd.): 0.250 parts by mass

(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.025 parts by mass

(c) Organic solvent: dipropylene glycol monobutyl ether (ether represented by the general formula (2) where n is 2; $R^2$ is $C_4H_9$; SP value $\alpha$ is 10.2 $(cal/cm^3)^{1/2}$; and vapor pressure is 5.3 Pa (20°C)) (manufactured by Wako Pure Chemical Corporation): 9.0 parts by mass

(d) Water: 90.7 parts by mass

Here, the total quantity of the above components (a) to (d) of the dyeing solution for lithographic printing plates accounts for 100 parts by mass.

The dyeing solution 6 for lithographic printing plates was evaluated by the methods described above and good results were obtained as follows: the first plate had a dye concentration of 0.66; the 1,000th plate had a dye concentration of 0.63; the dye concentration retention rate was 95.5%; and 4 plates suffered dyeing unevenness.

[Example 7]

The dyeing solution 7 for lithographic printing plates, instead of the dyeing solution 1 for lithographic printing plates, was evaluated by the same methods as used for Example 1.

<Dyeing solution 7 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.025 parts by mass
(c) Organic solvent: tripropylene glycol monomethyl ether (ether represented by the general formula (2) where n is 3; $R^2$ is $CH_3$; SP value $\alpha$ is 10.3 $(cal/cm^3)^{1/2}$; and vapor pressure is 4 Pa (20°C)) (manufactured by Tokyo Chemical Industry Co., Ltd.): 9.0 parts by mass
(d) Water: 90.7 parts by mass

Here, the total quantity of the above components (a) to (d) of the dyeing solution for lithographic printing plates accounts for 100 parts by mass.

The dyeing solution 7 for lithographic printing plates was evaluated by the methods described above and very good results were obtained as follows: the first plate had a dye concentration of 0.70; the 1,000th plate had a dye concentration of 0.68; the dye concentration retention rate was 97.1%; and 2 plates suffered dyeing unevenness.

[Example 8]

The dyeing solution 8 for lithographic printing plates, instead of the dyeing solution 1 for lithographic printing plates, was evaluated by the same methods as used for Example 1.

<Dyeing solution 8 for lithographic printing plates>

(a) Dye: Ethyl Violet (triphenyl methane based basic dye) (manufactured by Tokyo Chemical Industry Co., Ltd.): 0.500 parts by mass
(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.050 parts by mass
(c) Organic solvent: tripropylene glycol monomethyl ether (ether represented by the general formula (2) where n is 3; $R^2$ is $CH_3$; SP value $\alpha$ is 10.3 $(cal/cm^3)^{1/2}$; and vapor pressure is 4 Pa (20°C)) (manufactured by Tokyo Chemical Industry Co., Ltd.): 9.0 parts by mass
(d) Water: 90.5 parts by mass

Here, the total quantity of the above components (a) to (d) of the dyeing solution for lithographic printing plates accounts for 100 parts by mass.

The dyeing solution 8 for lithographic printing plates was evaluated by the methods described above and very good results were obtained as follows: the first plate had a dye concentration of 1.16; the 1,000th plate had a dye concentration of 1.11; the dye concentration retention rate was 95.7%; and 2 plates suffered dyeing unevenness.

[Example 9]

The dyeing solution 9 for lithographic printing plates, instead of the dyeing solution 1 for lithographic printing plates, was evaluated by the same methods as used for Example 1.

<Dyeing solution 9 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.025 parts by mass
(c) Organic solvent: tripropylene glycol (alcohol having a SP value $\alpha$ of 12.4 $(cal/cm^3)^{1/2}$ and a vapor pressure of 140 Pa (20°C)) (manufactured by Sigma-Aldrich): 9.0 parts by mass
(d) Water: 90.7 parts by mass

Here, the total quantity of the above components (a) to (d) of the dyeing solution for lithographic printing plates accounts for 100 parts by mass.
The dyeing solution 9 for lithographic printing plates was evaluated by the methods described above and very good results were obtained as follows: the first plate had a dye concentration of 0.66; the 1,000th plate had a dye concentration of 0.65; the dye concentration retention rate was 98.5%; and 4 plates suffered dyeing unevenness.

[Example 10]

The dyeing solution 10 for lithographic printing plates, instead of the dyeing solution 1 for lithographic printing plates, was evaluated by the same methods as used for Example 1.

<Dyeing solution 10 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.025 parts by mass
(c) Organic solvent: 3-methyl-3-methoxy butanol (alcohol having a SP value $\alpha$ of 10.5 $(cal/cm^3)^{1/2}$ and a vapor pressure of 67 Pa (20°C)) (manufactured by Tokyo Chemical Industry Co., Ltd.): 9.0 parts by mass
(d) Water: 90.7 parts by mass

Here, the total quantity of the above components (a) to (d) of the dyeing solution for lithographic printing plates accounts for 100 parts by mass.
The dyeing solution 10 for lithographic printing plates was evaluated by the methods described above and very good results were obtained as follows: the first plate had a dye concentration of 0.75; the 1,000th plate had a dye concentration of 0.74; the dye concentration retention rate was 98.7%; and 2 plates suffered dyeing unevenness.

[Comparative example 1]

The dyeing solution 11 for lithographic printing plates, instead of the dyeing solution 1 for lithographic printing plates, was evaluated by the same methods as used for Example 1.

<Dyeing solution 11 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium hexane sulfonate (represented by the general formula (1) where $R^1$ is a linear alkyl group having 6 carbon atoms and X is $SO_3Na$) (manufactured by Tokyo Chemical Industry Co., Ltd.): 0.025 parts by mass
(c) Organic solvent: butyl acetate (ester having a SP value $\alpha$ of 9.1 $(cal/cm^3)^{1/2}$ and a vapor pressure of 1,200 Pa (20°C)) (manufactured by Showa Chemical Industry Co., Ltd.): 9.0 parts by mass
(d) Water: 90.7 parts by mass

Here, the total quantity of the above components (a) to (d) of the dyeing solution for lithographic printing plates accounts for 100 parts by mass.

The dyeing solution 11 for lithographic printing plates was evaluated by the methods described above and results showed that the first plate and the 1,000th plate had a dye concentration of 0.19 and a dye concentration of 0.00, respectively, indicating that the plates were practically unacceptable in terms of dye concentration. This is considered to be because the dissolution stability of the dye in the dyeing solution was low to cause a decrease in dye concentration.

[Comparative example 2]

The dyeing solution 12 for lithographic printing plates, instead of the dyeing solution 1 for lithographic printing plates, was evaluated by the same methods as used for Example 1.

<Dyeing solution 12 for lithographic printing plates>

(a) Dye: Ethyl Violet (triphenyl methane based basic dye) (manufactured by Tokyo Chemical Industry Co., Ltd.): 0.250 parts by mass
(b) Nonionic surface active agent: polyoxyethylene lauryl ether (manufactured by Wako Pure Chemical Corporation): 0.025 parts by mass
(c) Organic solvent: tetrahydrofuran (ether having a SP value $\alpha$ of 9.1 (cal/cm$^3$)$^{1/2}$ and a vapor pressure of 18,900 Pa (20°C)) (manufactured by Mitsubishi Chemical Corporation): 9.0 parts by mass
(d) Water: 90.7 parts by mass

Here, the total quantity of the above components (a) to (d) of the dyeing solution for lithographic printing plates accounts for 100 parts by mass.

The dyeing solution 12 for lithographic printing plates was evaluated by the methods described above and results showed that the first plate and the 1,000th plate had a dye concentration of 0.20 and a dye concentration of 0.14, respectively, that the dye concentration retention rate was 70.0%, and that 30 plates suffered dyeing unevenness, indicating that the plates were practically unacceptable in terms of dye concentration and dyeing unevenness.

[Comparative example 3]

The dyeing solution 13 for lithographic printing plates, instead of the dyeing solution 1 for lithographic printing plates, was evaluated by the same methods as used for Example 1.

<Dyeing solution 13 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium butylnaphthalene sulfonate (represented by the general formula (1) where R$^1$ is a naphthyl group having a linear alkyl group having 4 carbon atoms and X is SO$_3$Na) (manufactured by Tokyo Chemical Industry Co., Ltd.): 0.025 parts by mass
(c) Organic solvent: tetrahydrofuran (ether having a SP value $\alpha$ of 9.1 (cal/cm$^3$)$^{1/2}$ and a vapor pressure of 18,900 Pa (20°C)) (manufactured by Mitsubishi Chemical Corporation): 9.0 parts by mass
(d) Water: 90.7 parts by mass

Here, the total quantity of the above components (a) to (d) of the dyeing solution for lithographic printing plates accounts for 100 parts by mass.

The dyeing solution 13 for lithographic printing plates was evaluated by the methods described above and results showed that the first plate and the 1,000th plate had a dye concentration of 0.24 and a dye concentration of 0.20, respectively, that the dye concentration retention rate was 83.3%, and that 32 plates suffered dyeing unevenness, indicating that the plates were practically unacceptable in terms of dye concentration and dyeing unevenness.

[Comparative example 4]

The dyeing solution 14 for lithographic printing plates, instead of the dyeing solution 1 for lithographic printing plates, was evaluated by the same methods as used for Example 1.

<Dyeing solution 14 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium 2-methyl-2-propene-1-sulfonate (represented by the general formula (1) where $R^1$ is a branched alkyl group having 4 carbon atoms and X is $SO_3Na$) (manufactured by Tokyo Chemical Industry Co., Ltd.): 0.025 parts by mass
(c) Organic solvent: tetrahydrofuran (ether having a SP value $\alpha$ of 9.1 $(cal/cm^3)^{1/2}$ and a vapor pressure of 18,900 Pa (20°C)) (manufactured by Mitsubishi Chemical Corporation): 9.0 parts by mass
(d) Water: 90.7 parts by mass

Here, the total quantity of the above components (a) to (d) of the dyeing solution for lithographic printing plates accounts for 100 parts by mass.
The dyeing solution 14 for lithographic printing plates was evaluated by the methods described above and results showed that the first plate and the 1,000th plate had a dye concentration of 0.50 and a dye concentration of 0.38, respectively, that the dye concentration retention rate was 76.0%, and that 24 plates suffered dyeing unevenness, indicating that the plates were practically unacceptable in terms of dyeing unevenness.

[Comparative example 5]

The dyeing solution 15 for lithographic printing plates, instead of the dyeing solution 1 for lithographic printing plates, was evaluated by the same methods as used for Example 1.

<Dyeing solution 15 for lithographic printing plates>

(a) Dye: Ethyl Violet (triphenyl methane based basic dye) (manufactured by Tokyo Chemical Industry Co., Ltd.): 0.250 parts by mass
(b) Anionic surface active agent: sodium hexylsulfate (represented by the general formula (1) where $R^1$ is a linear alkyl group having 6 carbon atoms and X is $SO_4Na$) (manufactured by Wako Pure Chemical Corporation): 0.025 parts by mass
(c) Organic solvent: tetrahydrofuran (ether having a SP value $\alpha$ of 9.1 $(cal/cm^3)^{1/2}$ and a vapor pressure of 18,900 Pa (20°C)) (manufactured by Mitsubishi Chemical Corporation): 9.0 parts by mass
(d) Water: 90.7 parts by mass

Here, the total quantity of the above components (a) to (d) of the dyeing solution for lithographic printing plates accounts for 100 parts by mass.
The dyeing solution 15 for lithographic printing plates was evaluated by the methods described above and results showed that the first plate and the 1,000th plate had a dye concentration of 0.49 and a dye concentration of 0.37, respectively, that the dye concentration retention rate was 75.5%, and that 25 plates suffered dyeing unevenness, indicating that the plates were practically unacceptable in terms of dyeing unevenness.

[Example 11]

(A) Preparation of waterless offset lithographic printing plate precursor 1

A solution of an organic layer composition as described below was spread over a degreased aluminum substrate with a thickness of 0.24 mm (manufactured by Mitsubishi Aluminum Co., Ltd.) and dried at 200°C for 90 seconds to form an organic layer with a thickness of 6.0 $\mu$m. The solution of an organic layer composition was prepared by stirring and mixing the following components at room temperature (20°C to 28°C).

<Solution of organic layer composition>

(a) Polymer having active hydrogen: epoxy resin: EPIKOTE® 1010 (manufactured by Japan Epoxy Resin Co., Ltd.): 35 parts by mass
(b) Polymer having active hydrogen: polyurethane: Sanprene® LQ-T1331D (manufactured by Sanyo Chemical Industries Ltd., solid content 20 mass%): 375 parts by mass
(c) Aluminum chelate: aluminum chelate ALCH TR (manufactured by Kawaken Fine Chemicals Co., Ltd.): 10 parts by mass
(d) Leveling agent: Disparlon® LC951 (manufactured by Kusumoto Chemicals Co., Ltd., solid content 10 mass%): 1 part by mass
(e) Titanium oxide: N,N-dimethyl formamide dispersion liquid of Tipaque® CR-50 (manufactured by Ishihara Sangyo Kaisha, Ltd.) (titanium oxide 50 mass%): 60 parts by mass
(f) N-N dimethyl formamide: 730 parts by mass
(g) Methyl ethyl ketone: 250 parts by mass

Subsequently, an image composition solution 1 was spread over the above organic layer with a wire bar coater and heated for drying at 140°C for 90 seconds to form a heat-sensitive layer with a thickness of 2.0 $\mu$m. Here, the image layer composition solution 1 was prepared by stirring and mixing the following components at room temperature (20°C to 28°C).

<Image layer composition solution 1>

(a) Infrared ray absorbing dye (cyanine pigment): NK5559 (manufactured by Hayashibara Co., Ltd., maximum absorption wavelength 774 nm): 16.0 parts by mass
(b) Polymer compound: methacrylic resin PARAPET™ (having a SP value $\beta$ of 9.1 (cal/cm$^3$)$^{1/2}$) (manufactured by KURARAY Co., Ltd.): 84 parts by mass
(c) Methyl ethyl ketone: 900 parts by mass

Subsequently, a solution of a silicone rubber layer composition, which had been prepared immediately before application, was applied over the above image layer with a wire bar coater and heated at 140°C for 80 seconds to form a silicone rubber layer with an average thickness of 2.0 $\mu$m, thereby providing a waterless offset lithographic printing plate precursor 1. Here, the solution of a silicone rubber layer composition was prepared by stirring and mixing the following components at room temperature (20°C to 28°C).

<Solution of silicone rubber layer composition>

(a) $\alpha,\omega$-divinylpolydimethyl siloxane: DMS-V35 (weight average molecular weight 49,500, manufactured by GELEST Inc.): 86.26 parts by mass
(b) Methyl hydrogen siloxane-dimethylsiloxane copolymer RD-1 (manufactured by Dow Corning Toray Co., Ltd.): 4.93 parts by mass
(c) Vinyl tris(methyl ethyl ketoximino) silane: 2.64 parts by mass
(d) Platinum catalyst SRX212 (manufactured by Dow Corning Toray Co., Ltd., platinum catalyst 6.0 mass%): 6.17 parts by mass
(e) Isopar® E (manufactured by Exxon Mobile Corporation): 900 parts by mass

(B) Preparation of dyeing solution 16 for lithographic printing plates

The dyeing solution 16 for lithographic printing plates was prepared by stirring and mixing the following components at room temperature.

<Dyeing solution 16 for lithographic printing plates>

(a) Dye: Rhodamine 6G (xanthene based basic dye) (manufactured by Tokyo Chemical Industry Co., Ltd.): 0.50 parts by mass
(c) Organic solvent: xylene (having a SP value $\alpha$ of 8.8 $(cal/cm^3)^{1/2}$) (manufactured by Wako Pure Chemical Corporation): 99.50 parts by mass

For the resulting waterless offset lithographic printing plate precursor 1 and the dyeing solution 16 for lithographic printing plates, an evaluation was made by the methods described above and the results obtained were as follows: the first plate had a dye concentration of 0.33; the 1,000th plate had a dye concentration of 0.25; the dye concentration retention rate was 75.8%; and 20 plates suffered dyeing unevenness.

[Example 12]

Except for replacing the waterless offset lithographic printing plate precursor 1 prepared from the image layer composition solution 1 with a waterless offset lithographic printing plate precursor 2 prepared from an image layer composition solution 2 as described below and replacing the dyeing solution 16 for lithographic printing plates with the undermentioned dyeing solution 17 for lithographic printing plates, the same procedure as in Example 11 was carried out to make an evaluation.

<Image layer composition solution 2>

(a) Infrared ray absorbing dye (cyanine pigment): NK5559 (manufactured by Hayashibara Co., Ltd., maximum absorption wavelength 774 nm): 16.0 parts by mass
(b) Polymer compound: phenol novolac resin Sumilite Resin® PR53195 (having a SP value $\beta$ of 16.4 $(cal/cm^3)^{1/2}$) (manufactured by Sumitomo Bakelite Co., Ltd.): 73.05 parts by mass
(c) Organic complex compound: titanium-n-butoxide bis(acetylacetonate): Nacem® Titanium (manufactured by Nihon Kagaku Sangyo Co., Ltd., concentration 73 mass%, containing 27 mass% n-butanol as solvent): 15.0 parts by mass
(d) Tetrahydrofuran: 895.95 parts by mass.

<Dyeing solution 17 for lithographic printing plates>

(a) Dye: Rhodamine 6G (xanthene based basic dye) (manufactured by Tokyo Chemical Industry Co., Ltd.): 0.50 parts by mass
(b) Anionic surface active agent: sodium behenate (represented by the general formula (1) where $R^1$ is a linear alkyl group having 21 carbon atoms and X is COONa): 0.05 parts by mass
(c) Organic solvent: methanol (alcohol having a SP value $\alpha$ of 13.8 $(cal/cm^3)^{1/2}$ and a vapor pressure of 12,300 Pa (20°C)) (manufactured by Wako Pure Chemical Corporation): 9.00 parts by mass
(d) Water: 90.45 parts by mass

For the resulting waterless offset lithographic printing plate precursor 2 and the dyeing solution 17 for lithographic printing plates, an evaluation was made by the methods described above and the results obtained were as follows: the first plate had a dye concentration of 0.70; the 1,000th plate had a dye concentration of 0.64; the dye concentration retention rate was 91.4%; and 14 plates suffered dyeing unevenness.

[Example 13]

Except for replacing the waterless offset lithographic printing plate precursor 1 prepared from the image layer composition solution 1 with a waterless offset lithographic printing plate precursor 3 prepared from an image layer composition solution 3 as described below and replacing the dyeing solution 16 for lithographic printing plates with the undermentioned dyeing solution 18 for lithographic printing plates, the same procedure as in Example 11 was carried out to make an evaluation.

<Image layer composition solution 3>

(a) Infrared ray absorbing dye (cyanine pigment): NK5559 (manufactured by Hayashibara Co., Ltd., maximum absorption wavelength 774 nm): 16.0 parts by mass
(b) Polymer compound: imino type methylated melamine resin Cymel 327 (having a SP value $\beta$ of 13.8 $(cal/cm^3)^{1/2}$)) (manufactured by ALLNEX): 83.0 parts by mass
(c) P-toluene sulfonic acid: 1.0 parts by mass
(d) Methyl ethyl ketone: 900 parts by mass

<Dyeing solution 18 for lithographic printing plates>

(a) Dye: Rhodamine 6G (xanthene based basic dye) (manufactured by Tokyo Chemical Industry Co., Ltd.): 0.50 parts by mass
(b) Anionic surface active agent: sodium behenate (represented by the general formula (1) where $R^1$ is a linear alkyl group having 21 carbon atoms and X is COONa): 0.05 parts by mass
(c) Organic solvent: dipropylene glycol monobutyl ether (ether represented by the general formula (2) where n is 2; $R^2$ is $C_4H_9$; the SP value $\alpha$ is 10.2 $(cal/cm^3)^{1/2}$; and the vapor pressure is 5.3 Pa (20°C)) (manufactured by Wako Pure Chemical Corporation): 9.0 parts by mass
(d) Water: 90.45 parts by mass

For the resulting waterless offset lithographic printing plate precursor 3 and the dyeing solution 18 for lithographic printing plates, an evaluation was made by the methods described above and good results were obtained as follows: the first plate had a dye concentration of 0.92; the 1,000th plate had a dye concentration of 0.88; the dye concentration retention rate was 95.7%; and 9 plates suffered dyeing unevenness.

[Example 14]

Except for using the undermentioned dyeing solution 19 for lithographic printing plates, instead of the dyeing solution 18 for lithographic printing plates, an evaluation was made by the same methods as used for Example 13.

<Dyeing solution 19 for lithographic printing plates>

(a) Dye: Rhodamine 6G (xanthene based basic dye) (manufactured by Tokyo Chemical Industry Co., Ltd.): 0.50 parts by mass
(b) Anionic surface active agent: sodium behenate (represented by the general formula (1) where $R^1$ is a linear alkyl group having 21 carbon atoms and X is COONa): 0.05 parts by mass
(c) Organic solvent: 3-methyl-3-methoxy butanol (alcohol having a SP value $\alpha$ of 10.5 $(cal/cm^3)^{1/2}$ and a vapor pressure of 67 Pa (20°C)) (manufactured by Tokyo Chemical Industry Co., Ltd.): 9.0 parts by mass
(d) Water: 90.45 parts by mass

For the resulting dyeing solution 19 for lithographic printing plates, an evaluation was made by the methods described above and good results were obtained as follows: the first plate had a dye concentration of 1.01; the 1,000th plate had a dye concentration of 0.96; the dye concentration retention rate was 95.0%; and 7 plates suffered dyeing unevenness.

[Example 15]

Except for using the undermentioned dyeing solution 20 for lithographic printing plates, instead of the dyeing solution 18 for lithographic printing plates, an evaluation was made by the same methods as used for Example 13.

<Dyeing solution 20 for lithographic printing plates>

(a) Dye: Rhodamine 6G (xanthene based basic dye) (manufactured by Tokyo Chemical Industry Co., Ltd.): 0.50 parts by mass
(b) Anionic surface active agent: sodium behenate (represented by the general formula (1) where $R^1$ is a linear alkyl group having 21 carbon atoms and X is COONa): 0.05 parts by mass
(c) Organic solvent: tripropylene glycol (alcohol having a SP value $\alpha$ of 12.4 $(cal/cm^3)^{1/2}$ and a vapor pressure of 140 Pa (20°C)) (manufactured by Sigma-Aldrich): 9.0 parts by mass
(d) Water: 90.45 parts by mass

For the resulting dyeing solution 20 for lithographic printing plates, an evaluation was made by the methods described above and good results were obtained as follows: the first plate had a dye concentration of 1.02; the 1,000th plate had a dye concentration of 0.97; the dye concentration retention rate was 95.1%; and 7 plates suffered dyeing unevenness.

[Example 16]

For the waterless offset lithographic printing plate precursor 2 and the dyeing solution 20 for lithographic printing plates, an evaluation was made by the methods described above and results were obtained as follows: the first plate had a dye concentration of 1.00; the 1,000th plate had a dye concentration of 0.95; the dye concentration retention rate was 95.0%; and 6 plates suffered dyeing unevenness.

[Example 17]

Except for using the undermentioned dyeing solution 21 for lithographic printing plates, instead of the dyeing solution 20 for lithographic printing plates, an evaluation was made by the same methods as used for Example 16.

<Dyeing solution 21 for lithographic printing plates>

(a) Dye: Rhodamine 6G (xanthene based basic dye) (manufactured by Tokyo Chemical Industry Co., Ltd.): 0.50 parts by mass
(b) Anionic surface active agent: sodium hexane sulfonate (represented by the general formula (3) where $R^1$ is a linear alkyl group having 6 carbon atoms and X is $SO_3Na$) (manufactured by Tokyo Chemical Industry Co., Ltd.): 0.05 parts by mass
(c) Organic solvent: tripropylene glycol (alcohol having a SP value $\alpha$ of 12.4 $(cal/cm^3)^{1/2}$ and a vapor pressure of 140 Pa (20°C)) (manufactured by Sigma-Aldrich): 9.0 parts by mass
(d) Water: 90.45 parts by mass

For the resulting dyeing solution 21 for lithographic printing plates, an evaluation was made by the methods described above and very good results were obtained as follows: the first plate had a dye concentration of 1.06; the 1,000th plate had a dye concentration of 1.01; the dye concentration retention rate was 95.3%; and 3 plates suffered dyeing unevenness.

[Example 18]

Except that a light exposure of 150 $mJ/cm^2$, instead of 125 $mJ/cm^2$, was applied to the waterless offset lithographic printing plate precursor 2, an evaluation was made by the same methods as used for Example 17.
An evaluation was made by the methods described above and very good results were obtained as follows: the first plate had a dye concentration of 1.20; the 1,000th plate had a dye concentration of 1.18; the dye concentration retention rate was 98.3%; and 3 plates suffered dyeing unevenness.

[Example 19]

Except that the waterless offset lithographic printing plate precursor 2 was developed in a development tank that contained tap water instead of a 10% aqueous triethylene glycol solution, an evaluation was made by the same methods as used for Example 18.

An evaluation was made by the methods described above and very good results were obtained as follows: the first plate had a dye concentration of 1.20; the 1,000th plate had a dye concentration of 1.18; the dye concentration retention rate was 98.3%; and a plate suffered dyeing unevenness.

[Example 20]

Except for drying the image area in hot air to remove the post-treatment solution after the light-exposed waterless offset lithographic printing plate precursor 2 had passed through the post-treatment tank, an evaluation was made by the same methods as used for Example 19. An evaluation was made by the methods described above and very good results were obtained as follows: the first plate had a dye concentration of 1.30; the 1,000th plate had a dye concentration of 1.29; the dye concentration retention rate was 99.2%; and no plates suffered dyeing unevenness.

[Comparative example 6]

Except for replacing the waterless offset lithographic printing plate precursor 1 prepared from the image layer composition solution 1 with a waterless offset lithographic printing plate precursor 4 prepared from an image layer composition solution 4 as described below, the same procedure as in Example 11 was carried out to make an evaluation.

<Image layer composition solution 4>

(a) Infrared ray absorbing dye (cyanine pigment): NK5559 (manufactured by Hayashibara Co., Ltd., maximum absorption wavelength 774 nm): 16.0 parts by mass
(b) Polymer compound: carboxymethyl cellulose (having a SP value $\beta$ of 19.5 $(cal/cm^3)^{1/2}$)) (manufactured by Daicel FineChem Ltd.): 84 parts by mass
(c) Methyl ethyl ketone: 900 parts by mass

For the resulting waterless offset lithographic printing plate precursor 4 and the dyeing solution 19 for lithographic printing plates, an evaluation was made by the methods described above and results were obtained as follows: the first plate had a dye concentration of 0.18; the 1,000th plate had a dye concentration of 0.10; the dye concentration retention rate was 55.6%, and 52 plates suffered dyeing unevenness, indicating that the plates were practically unacceptable in terms of dye concentration and dyeing unevenness. The above evaluation results are summarized in Table 1, Table 2, Table 3, and Table 4.

[Table 1]

| | | | (a) dye | | (b) surface active agent | | (c) organic solvent | |
|---|---|---|---|---|---|---|---|---|
| | | | | Components of dyeing solution | | | | |
| | | | name | Content (parts by mass) | name | Content (parts by mass) | name | Content (parts by mass) |
| Example s | (1) | | Rhodamine 6G | 0.250 | sodium behenate | 0.025 | methanol | 9.0 |
| | (2) | | Ethyl Violet | 0.250 | sodium behenate | 0.025 | methanol | 9.0 |
| | (3) | | Ethyl Violet | 0.250 | sodium stearate | 0.025 | methanol | 9.0 |
| | (4) | | Ethyl Violet | 0.250 | sodium octane sulfonate | 0.025 | methanol | 9.0 |
| | (5) | | Ethyl Violet | 0.250 | sodium hexane sulfonate | 0.025 | methanol | 9.0 |
| | (6) | | Ethyl Violet | 0.250 | sodium hexane sulfonate | 0.025 | dipropylene glycol monobutyl ether | 9.0 |
| | (7) | | Ethyl Violet | 0.250 | sodium hexane sulfonate | 0.025 | tripropylene glycol monomethyl ether | 9.0 |
| | (8) | | Ethyl Violet | 0.500 | sodium hexane sulfonate | 0.050 | tripropylene glycol monomethyl ether | 9.0 |
| | (9) | | Ethyl Violet | 0.250 | sodium hexane sulfonate | 0.025 | tripropylene glycol | 9.0 |
| | (10) | | Ethyl Violet | 0.250 | sodium hexane sulfonate | 0.025 | 3-methyl-3-methoxy butanol | 9.0 |
| Comparative example s | (1) | | Ethyl Violet | 0.250 | sodium hexane sulfonate | 0.025 | butyl acetate | 9.0 |
| | (2) | | Ethyl Violet | 0.250 | polyoxyethylene lauryl ether | 0.025 | tetrahydrofuran | 9.0 |
| | (3) | | Ethyl Violet | 0.250 | sodium butyl naphthalene sulfonate | 0.025 | tetrahydrofuran | 9.0 |
| | (4) | | Ethyl Violet | 0.250 | sodium 2-methyl-2-propene-1-sulfonate | 0.025 | tetrahydrofuran | 9.0 |
| | (5) | | Ethyl Violet | 0.250 | sodium hexylsulfate | 0.025 | tetrahydrofuran | 9.0 |

[Table 2]

| | | Evaluation | | | |
|---|---|---|---|---|---|
| | | dye concentration | | dye concentration retention rate (%) | dyeing unevenness |
| | | (A) first plate | (B) 1,000th plate | (B)/(A) × 100 | |
| Examples | (1) | 0.45 | 0.35 | 77.8 | 18 |
| | (2) | 0.61 | 0.47 | 77.0 | 18 |
| | (3) | 0.55 | 0.42 | 76.4 | 14 |
| | (4) | 0.52 | 0.40 | 76.9 | 10 |
| | (5) | 0.52 | 0.40 | 76.9 | 10 |
| | (6) | 0.66 | 0.63 | 95.5 | 4 |
| | (7) | 0.70 | 0.68 | 97.1 | 2 |
| | (8) | 1.16 | 1.11 | 95.7 | 2 |
| | (9) | 0.66 | 0.65 | 98.5 | 4 |
| | (10) | 0.75 | 0.74 | 98.7 | 2 |
| Comparative examples | (1) | 0.19 | 0.00 | 0.0 | - |
| | (2) | 0.20 | 0.14 | 70.0 | 30 |
| | (3) | 0.24 | 0.20 | 83.3 | 32 |
| | (4) | 0.50 | 0.38 | 76.0 | 24 |
| | (5) | 0.49 | 0.37 | 75.5 | 25 |

[Table 3]

| | | dyeing solution composition | | | image layer composition | | difference in SP value ($\beta$-$\alpha$) | preparation steps for lithographic printing plate | | |
|---|---|---|---|---|---|---|---|---|---|---|
| | | organic solvent | | anionic surface active agent | polymer compound | | | light exposure step | development step | dyeing step |
| | | name | SP value $\alpha$ (cal/cm$^3$)$^{1/2}$ | name | name | SP value $\beta$ (cal/cm$^3$)$^{1/2}$ | | light exposure (mJ/cm$^2$) | developer | drying method |
| Examples | (11)* | xylene | 8.8 | none | methacrylic resin | 9.1 | 0.3 | 125 | 10% aqueous triethylene glycol solution | not performed |
| | (12) | methanol | 13.8 | sodium behenate | phenol novolac resin | 16.4 | 1.8 | 125 | 10% aqueous triethylene glycol solution | not performed |
| | (13) | dipropylene glycol monobutyl ether | 10.2 | sodium behenate | imino type methylated melamine resin | 13.8 | 3.3 | 125 | 10% aqueous triethylene glycol solution | not performed |
| | (14) | 3-methyl-3-methoxy butanol | 10.5 | sodium behenate | imino type methylated melamine resin | 13.8 | 4.0 | 125 | 10% aqueous triethylene glycol solution | not performed |
| | (15) | tripropylene glycol | 12.4 | sodium behenate | imino type methylated melamine resin | 13.8 | 1.4 | 125 | 10% aqueous triethylene glycol solution | not performed |
| | (16) | tripropylene glycol | 12.4 | sodium behenate | phenol novolac resin | 16.4 | 4.0 | 125 | 10% aqueous triethylene glycol solution | not performed |
| | (17) | tripropylene glycol | 12.4 | sodium hexane sulfonate | phenol novolac resin | 16.4 | 4.0 | 125 | 10% aqueous triethylene glycol solution | not performed |
| | (18) | tripropylene glycol | 12.4 | sodium hexane sulfonate | phenol novolac resin | 16.4 | 4.0 | 150 | 10% aqueous triethylene glycol solution | not performed |

EP 3 988 319 B1

24

(continued)

| | | dyeing solution composition | | | image layer composition | | difference in SP value ($\beta$-$\alpha$) | preparation steps for lithographic printing plate | | |
|---|---|---|---|---|---|---|---|---|---|---|
| | | organic solvent | | anionic surface active agent | polymer compound | | | light exposure step | development step | dyeing step |
| | | name | SP value $\alpha$ (cal/cm$^3$)$^{1/2}$ | name | name | SP value $\beta$ (cal/cm$^3$)$^{1/2}$ | | light exposure (mJ/cm$^2$) | developer | drying method |
| | (19) | tripropylene glycol | 12.4 | sodium hexane sulfonate | phenol novolac resin | 16.4 | 4.0 | 150 | water | not performed |
| | (20) | tripropylene glycol | 12.4 | sodium hexane sulfonate | phenol novolac resin | 16.4 | 4.0 | 150 | water | hot-air drying |
| Comparative example (6) | | xylene | 8.8 | none | carboxymethyl cellulose | 19.5 | 107 | 125 | 10% aqueous triethylene glycol solution | not performed |
| *comparative example - not in accordance with the present invention | | | | | | | | | | |

[Table 4]

| | | Evaluation | | | |
|---|---|---|---|---|---|
| | | dye concentration | | dye concentration retention rate (%) | dyeing unevenness |
| | | (A) first plate | (B) 1,000th plate | (B)/(A) $\times$ 100 | |
| Examples | (11) | 0.33 | 0.25 | 75.8 | 20 |
| | (12) | 0.70 | 0.64 | 91.4 | 14 |
| | (13) | 0.92 | 0.88 | 95.7 | 9 |
| | (14) | 1.01 | 0.96 | 95.0 | 7 |
| | (15) | 1.02 | 0.97 | 95.1 | 7 |
| | (16) | 1.00 | 0.95 | 95.0 | 6 |
| | (17) | 1.06 | 1.01 | 95.3 | 3 |
| | (18) | 1.20 | 1.18 | 98.3 | 3 |
| | (19) | 1.20 | 1.18 | 98.3 | 1 |
| | (20) | 1.30 | 1.29 | 99.2 | 0 |
| Comparative example (6) | | 0.18 | 0.10 | 55.6 | 52 |

**Claims**

1. A dyeing method for lithographic printing plates, wherein an image area is dyed using a dyeing solution for lithographic printing plates comprising

   (a) dye,
   (b) an anionic surface active agent, and
   (c) an organic solvent containing at least one selected from ethers and alcohols; during or after the development of a lithographic printing plate precursor

   **characterized in that** the anionic surface active agent (b) is represented by the general formula (1):

   $$R^1\text{-}X \qquad (1)$$

   wherein $R^1$ represents a linear alkyl group having 3 to 30 carbon atoms or a linear alkenyl group having 3 to 30 carbon atoms, and X represents $SO_3Na$, $SO_3K$, $COONa$, $COONH_4$, or $COOK$.

2. A method for dyeing an image area formed on a waterless offset lithographic printing plate with a dyeing solution containing an organic solvent, the image area including a polymer compound and the method being further **characterized in that** the SP value of the organic solvent, denoted by $\alpha$, and the SP value of the polymer compound, denoted by $\beta$, hold the following relation: $|\beta\text{-}\alpha| < 5$ $(cal/cm^3)^{1/2}$, the polymer compound is a phenol resin and/or a melamine resin, the organic solvent is an ether and/or an alcohol, the ether is either dipropylene glycol monoalkyl ether or a tripropylene glycol monoalkyl ether as represented by the general formula (2) given below:

   $$R^2\text{-}(OC_3H_6)n\text{-}OH \qquad (2)$$

   wherein $R^2$ is $CH_3$, $C_2H_5$, $C_3H_7$, $C_4H_9$, $C_5H_{11}$, or $C_6H_{13}$; n is 2 or 3; and the $(OC_3H_6)$ chains may be independently branched or linear, and the alcohol being either tripropylene glycol or 3-methyl-3-methoxy butanol.

3. A method for dyeing a waterless offset lithographic printing plate as set forth in claim 2, wherein the SP value of the organic solvent, denoted by $\alpha$, and the SP value of the polymer compound, denoted by $\beta$, holds the following relation: $1$ $(cal/cm^3)^{1/2} < \beta\text{-}\alpha < 5$ $(cal/cm^3)^{1/2}$.

**4.** A method for dyeing a waterless offset lithographic printing plate as set forth in either claim 2 or 3, wherein the SP value of the polymer compound, denoted by $\beta$, is in the range of 10 to 17 $(cal/cm^3)^{1/2}$.

**5.** A method for dyeing a waterless offset lithographic printing plate as set forth in any one of claims 2 to 4, wherein the SP value of the organic solvent, denoted by $\alpha$, is in the range of 9.0 to 13.0 $(cal/cm^3)^{1/2}$.

**6.** A method for dyeing a waterless offset lithographic printing plate as set forth in any one of claims 2 to 5, wherein the dyeing solution further contains an anionic surface active agent.

**7.** A method for dyeing a waterless offset lithographic printing plate as set forth in any one of claims 2 to 6, including a step for bringing the dyeing solution into contact with the image area and drying the dyeing solution on the image area.

**Patentansprüche**

**1.** Färbeverfahren für lithographische Druckplatten, wobei ein Bildbereich unter Verwendung einer Färbelösung für lithographische Druckplatten, die umfasst:

(a) einen Farbstoff,
(b) ein anionisches oberflächenaktives Mittel, und
(c) ein organisches Lösungsmittel, das Ether und/oder Alkohole enthält,
während oder nach der Entwicklung eines lithographischen Druckplattenvorläufers gefärbt wird,
**dadurch gekennzeichnet, dass** das anionische oberflächenaktive Mittel (b) durch die allgemeine Formel (1) wiedergegeben wird:

$$R^1\text{-}X \qquad (1)$$

wobei $R^1$ für eine lineare Alkylgruppe mit 3 bis 30 Kohlenstoffatomen oder eine lineare Alkenylgruppe mit 3 bis 30 Kohlenstoffatomen steht und X für $SO_3Na$, $SO_3K$, $COONa$, $COONH_4$ oder $COOK$ steht.

**2.** Verfahren zum Färben eines Bildbereichs, der auf einer wasserlosen lithographischen Offsetdruckplatte gebildet wird, mit einer Färbelösung, die ein organisches Lösungsmittel enthält, wobei der Bildbereich eine Polymerverbindung enthält und wobei das Verfahren weiterhin **dadurch gekennzeichnet ist, dass** der SP-Wert des organischen Lösungsmittels, angeben durch $\alpha_1$ und der SP-Wert der Polymerverbindung, angegeben durch $\beta$, die folgende Beziehung erfüllen: $|\beta\text{-}\alpha| < 5$ $(cal/cm^3)^{1/2}$, wobei die Polymerverbindung ein Phenolharz und/oder ein Melaminharz ist, wobei das organische Lösungsmittel ein Ether und/oder ein Alkohol ist, wobei der Ether entweder Dipropylenglycolmonoalkylether oder Tripropylenglycolmonoalkylether, wie durch die folgende allgemeine Formel (2) wiedergegeben, ist:

$$R\text{-}(OC_3H_6)n\text{-}OH \qquad (2)$$

wobei $R^2$ für $CH_3$, $C_2H_5$, $C_3H_7$, $C_4H_9$, $C_5H_{11}$ oder $C_6H_{13}$ steht, n für 2 oder 3 steht, die $(OC_3H_6)$-Ketten jeweils unabhängig voneinander verzweigt oder linear sein können und der Alkohol entweder Tripropylenglycol oder 3-Methyl-3-methoxybutanol ist.

**3.** Verfahren zum Färben einer wasserlosen lithographischen Offsetdruckplatte nach Anspruch 2, wobei der SP-Wert des organischen Lösungsmittels, angegeben durch $\alpha_1$ und der SP-Wert der Polymerverbindung, angegeben durch $\beta$, die folgende Beziehung erfüllen: $1$ $(cal/cm^3)^{1/2} < \beta\text{-}\alpha < 5$ $(cal/cm^3)^{1/2}$.

**4.** Verfahren zum Färben einer wasserlosen lithographischen Offsetdruckplatte nach Anspruch 2 oder 3, wobei der SP-Wert der Polymerverbindung, angegeben durch $\beta$, im Bereich von 10 bis 17 $(cal/cm^3)^{1/2}$ liegt.

**5.** Verfahren zum Färben einer wasserlosen lithographischen Offsetdruckplatte nach einem der Ansprüche 2 bis 4, wobei der SP-Wert des organischen Lösungsmittels, angegeben durch $\alpha$, im Bereich von 9,0 bis 13,0 $(cal/cm^3)^{1/2}$ liegt.

**6.** Verfahren zum Färben einer wasserlosen lithographischen Offsetdruckplatte nach einem der Ansprüche 2 bis 5, wobei die Färbelösung weiterhin ein anionisches oberflächenaktives Mittel enthält.

7. Verfahren zum Färben einer wasserlosen lithographischen Offsetdruckplatte nach einem der Ansprüche 2 bis 6, das einen Schritt zum Bringen der Färbelösung in einen Kontakt mit dem Bildbereich und zum Trocknen der Färbelösung auf dem Bildbereich umfasst.

**Revendications**

1. Procédé de teinture pour plaques d'impression lithographique, dans lequel une zone d'image est teintée à l'aide d'une solution de teinture pour plaques d'impression lithographique comprenant

   (a) du colorant,
   (b) un agent tensioactif anionique, et
   (c) un solvant organique contenant au moins un élément choisi parmi les éthers et les alcools ; pendant ou après le développement d'un précurseur de plaque d'impression lithographique

   **caractérisé en ce que** l'agent tensioactif anionique (b) est représenté par la formule générale (1) :

   $$R^1\text{-}X \qquad (1)$$

   dans laquelle $R^1$ représente un groupe alkyle linéaire ayant de 3 à 30 atomes de carbone ou un groupe alcényle linéaire ayant de 3 à 30 atomes de carbone, et X représente $SO_3Na$, $SO_3K$, COONa, $COONH_4$ ou COOK.

2. Procédé de teinture d'une zone d'image formée sur une plaque d'impression lithographique offset sans eau avec une solution de teinture contenant un solvant organique, la zone d'image incluant un composé polymère et le procédé étant en outre **caractérisé en ce que** la valeur SP du solvant organique, désignée par $\alpha$, et la valeur SP du composé polymère, désignée par $\beta$, sont conformes à la relation suivante : $|\beta-\alpha| < 5$ $(cal/cm^3)^{1/2}$, le composé polymère est une résine phénolique et/ou une résine mélamine, le solvant organique est un éther et/ou un alcool, l'éther est soit un éther monoalkylique de dipropylène glycol, soit un éther monoalkylique de tripropylène glycol, tel que représenté par la formule générale (2) ci-dessous :

   $$R^2\text{-}(OC_3H_6)n\text{-}OH \qquad (2)$$

   dans laquelle $R^2$ est $CH_3$, $C_2H_5$, $C_3H_7$, $C_4H_9$, $C_5H_{11}$ ou $C_6H_{13}$ ; n est 2 ou 3 ; et les chaînes $(OC_3H_6)$ peuvent être indépendamment ramifiées ou linéaires, et l'alcool étant soit du tripropylène glycol, soit du 3- méthyl-3-méthoxybutanol.

3. Procédé de teinture d'une plaque d'impression lithographique offset sans eau selon la revendication 2, dans lequel la valeur SP du solvant organique, désignée par $\alpha$, et la valeur SP du composé polymère, désignée par $\beta$, sont conformes à la relation suivante : $1$ $(cal/cm^3)^{1/2} < \beta\text{-}\alpha < 5$ $(cal/cm^3)^{1/2}$.

4. Procédé de teinture d'une plaque d'impression lithographique offset sans eau selon la revendication 2 ou 3, dans lequel la valeur SP du composé polymère, désignée par $\beta$, est dans la plage allant de 10 à 17 $(cal/cm^3)^{1/2}$.

5. Procédé de teinture d'une plaque d'impression lithographique offset sans eau selon l'une quelconque des revendications 2 à 4, dans lequel la valeur SP du solvant organique, désignée par $\alpha$, est dans la plage allant de 9,0 à 13,0 $(cal/cm^3)^{1/2}$.

6. Procédé de teinture d'une plaque d'impression lithographique offset sans eau selon l'une quelconque des revendications 2 à 5, dans lequel la solution de teinture contient en outre un agent tensioactif anionique.

7. Procédé de teinture d'une plaque d'impression lithographique offset sans eau selon l'une quelconque des revendications 2 à 6, incluant une étape de mise en contact de la solution de teinture avec la zone d'image et de séchage de la solution de teinture sur la zone d'image.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI934132 A
- JP 2004233610 A
- CN 105440792 A
- CN 104893404 A
- JP S63165466 A
- EP 1234860 A1
- JP H06202313 A
- JP H1039497 A
- JP H0829971 B
- JP 4839987 B